# FASCICULE DE BREVET EUROPEEN

(11) **EP 1 979 945 B1**
(45) Date de publication et mention de la délivrance du brevet: **31.08.2011**
(21) Numéro de dépôt: 07730884.9
(22) Date de dépôt: 29.01.2007
(51) Int. Cl.: H01L 25/16

(54) **DISPOSITIF D EMISSION DE LUMIERE AVEC CONTROLE CHROMATIQUE**
LICHTEMISSIONSVORRICHTUNG MIT FARBSTEUERUNG
LIGHT EMISSION DEVICE WITH CHROMATIC CONTROL

(30) Priorité: 31.01.2006 FR 0600867
(43) Date de publication de la demande: 15.10.2008
(73) Titulaire: Commissariat à l'Énergie Atomique et aux Énergies Alternatives, 75015 Paris (FR)
(72) Inventeur: KOPP, Christophe, F-38120 Fontanil-Cornillon (FR); HUGON, Xavier, F-38500 Voiron (FR); MOUREY, Bruno, F-38500 Coublevie (FR); TCHELNOKOV, Alexei, F-38000 Grenoble (FR)
(74) Mandataire: Hecké, Gérard
(86) Numéro de dépôt international: PCT/FR2007/000166
(87) Numéro de publication internationale: WO 2007/088267

(56) Documents cités:
- WO-A-02/099333
- WO-A2-03/010830
- US-A- 5 965 875
- US-A1- 2002 047 624

## Description

### Domaine technique de l'invention

L'invention concerne un dispositif d'émission de lumière comportant :
- un substrat de base,
- au moins deux diodes électroluminescentes, respectivement associées à deux couleurs distinctes et disposées côte à côte sur ledit substrat de base,
- des moyens de détection chromatique,
- des moyens de contrôle, connectés auxdits moyens de détection chromatique et aux diodes électroluminescentes, pour contrôler la couleur globale de la lumière émise par le dispositif.

### État de la technique

Une source de lumière blanche est classiquement obtenue à partir de plusieurs groupes de sources de couleurs données. Un dispositif d'émission de lumière classique génère une lumière blanche à partir d'un jeu de trois groupes de diodes électroluminescentes (LEDs) de trois couleurs différentes, par exemple rouge, vert et bleu.

Le brevet US 5 301 090 décrit notamment un dispositif d'émission de lumière blanche, obtenue par la combinaison d'émetteurs monochromatiques, du type diodes électroluminescentes. Les émetteurs sont de différentes couleurs, par exemple un bleu, un rouge et un vert, sont assemblés les uns à la suite des autres et sont reliés à un contrôleur, permettant de régler la lumière émise par le dispositif. Cependant, un tel dispositif ne permet pas de contrôler les dérives chromatiques et les dérives en puissance des différents émetteurs.

Le document WO-A-02/052902 décrit un appareil d'éclairage comprenant une pluralité de diodes électroluminescentes de trois couleurs différentes, destinées à générer une lumière blanche. L'ajustement de la couleur blanche émise par les groupes de diodes s'effectue de façon dynamique par des boutons. Pour savoir comment régler les diodes, la puissance émise par chaque groupe de diodes d'une même couleur est mesurée séquentiellement par une même photodiode. Chaque groupe de diode est alors allumé successivement pour effectuer les mesures, les deux autres groupes s'éteignant pendant une brève impulsion. Cependant, ce type d'appareil ne permet pas de contrôler les dérives chromatiques de chaque groupe de diodes électroluminescentes.

Le brevet US 6 741 351 décrit un dispositif d'émission de lumière, du même type que celui décrit ci-dessus, comprenant une photodiode avec des filtres colorés, qui permutent successivement, ou plusieurs photodiodes comprenant chacune un filtre coloré fixe. Cependant, un tel dispositif ne permet pas de contrôler les dérives chromatiques des filtres colorés et les dérives chromatiques des diodes électroluminescentes.

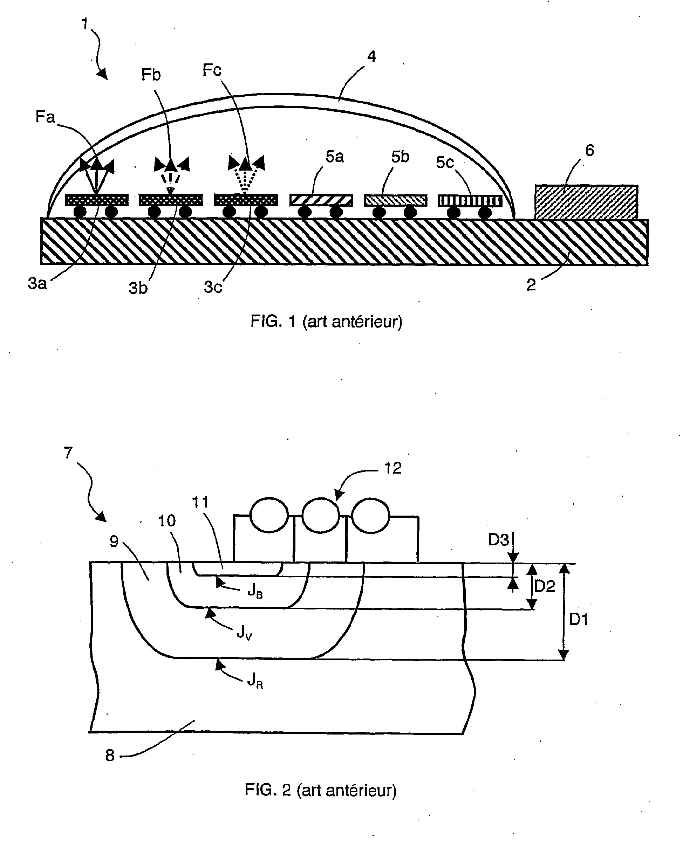

Un autre exemple de dispositif 1 d'émission de lumière classique est représenté schématiquement sur la figure 1. Le dispositif 1 d'émission de lumière comporte un substrat de base 2 sur lequel sont formées trois diodes électroluminescentes 3a, 3b, 3c émettrices de faisceaux Fa, Fb, Fc, respectivement associés, par exemple, aux trois couleurs primaires rouge, verte et bleue.

Les diodes électroluminescentes 3a, 3b, 3c sont disposées côte à côte sur le substrat de base 2, au-dessous d'une lentille 4, partiellement réfléchissante, apte à réfléchir les faisceaux lumineux Fa, Fb, Fc en direction du substrat de base 2. Le dispositif 1 comporte trois photodiodes 5a, 5b, 5c de détection chromatique des faisceaux lumineux réfléchis par la lentille 4, respectivement associés aux trois couleurs primaires rouge, verte et bleue. Les photodiodes 5a, 5b, 5c comportent chacune, de préférence, un filtre coloré (non représenté), permettant de mesurer uniquement l'intensité de la couleur primaire qui lui est associée.

Les photodiodes 5a, 5b, 5c sont adjacentes aux diodes électroluminescentes 3a, 3b, 3c et la lentille 4 délimite un volume au-dessus des diodes électroluminescentes 3a, 3b, 3c et des photodiodes 5a, 5b, 5c, sur le substrat de base 2. Le dispositif 1 comprend également un composant de contrôle 6, placé sur le substrat de base 2 et connecté aux diodes électroluminescentes 3a, 3b, 3c et aux photodiodes 5a, 5b, 5c. Le composant de contrôle 6 permet notamment de contrôler la couleur globale de la lumière émise par le dispositif 1 d'émission de lumière.

Le document WO03010830 décrit un support comportant des diodes électroluminescentes. Un capteur est disposé sur le support à proximité des diodes. Le capteur fournit à un contrôleur extérieur des données représentatives de la luminosité et de la longueur d'ondes des diodes. Ce capteur peut être de type photodiode.

Aucun des appareils décrits ci-dessus ne permet de contrôler les dérives chromatiques des diodes électroluminescentes en fonction de la puissance émise ou, dans le cas de l'utilisation de filtres colorés, de contrôler les dérives chromatiques des filtres colorés dues à leur vieillissement. De plus, aucun des appareils ne permet de garantir l'obtention d'une couleur donnée.

### Objet de l'invention

L'invention a pour but de remédier à l'ensemble des inconvénients précités et a pour objet la réalisation d'un dispositif d'émission de lumière permettant le contrôle chromatique de la couleur globale de la lumière émise, tout en améliorant la fiabilité à long terme du dispositif.

Le but de l'invention est atteint par les revendications annexées et, plus particulièrement, par le fait que :
- les moyens de détection chromatique comportent au moins un photodétecteur chromatique mesurant les composantes chromatiques du signal émis par les diodes électroluminescentes à différents niveaux enterrés dans un substrat semi-conducteur et respectivement associés à des longueurs d'ondes correspondant aux composantes chromatiques,
- ledit photodétecteur chromatique comporte au moins des première et deuxième couches superposées dans ledit substrat semi-conducteur, la première couche ayant un premier type de conductivité et la seconde couche ayant un second type de conductivité.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente schématiquement une vue en coupe d'un dispositif d'émission de lumière selon l'art antérieur.
La figure 2 représente très schématiquement un photodétecteur chromatique selon l'art antérieur, utilisé dans un dispositif d'émission de lumière selon l'invention.
La figure 3 représente schématiquement une vue en coupe d'un premier mode de réalisation d'un dispositif d'émission de lumière selon l'invention.
La figure 4 représente schématiquement une vue en coupe d'une variante de réalisation d'un dispositif d'émission de lumière selon l'invention.
La figure 5 représente schématiquement une vue en coupe d'une autre variante de réalisation d'un dispositif d'émission de lumière ne faisant pas partie de l'invention revendiquée.

### Description de modes particuliers de réalisation

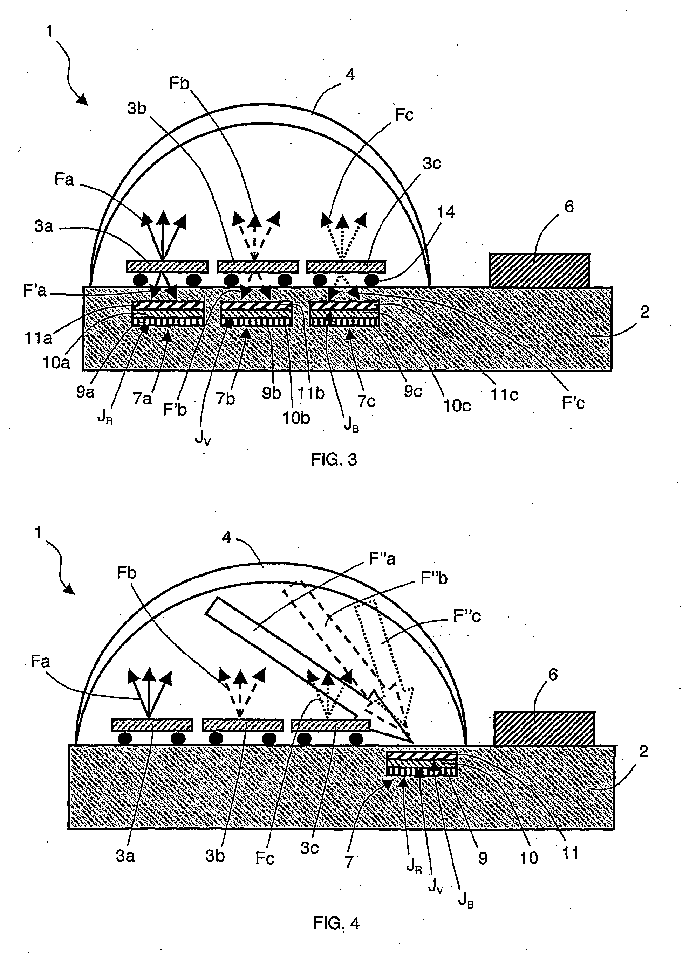

Sur les figures 3 à 5, le dispositif 1 d'émission de lumière est particulièrement destiné à optimiser le contrôle chromatique de la couleur globale de la lumière émise, en contrôlant notamment l'intensité de trois diodes électroluminescentes 3, respectivement associées à trois couleurs primaires, par exemple le rouge, le vert et le bleu.

Les moyens de détection chromatique utilisés dans les différents modes particuliers de réalisation du dispositif 1 d'émission de lumière, comme représenté sur les figures 3 à 5, comportent notamment au moins un photodétecteur chromatique 7, comme décrit dans le brevet US 5 965 875 et comme représenté schématiquement sur la figure 2.

Sur la figure 2, le photodétecteur chromatique 7 est destiné à mesurer les composantes chromatiques rouge, verte et bleue de la lumière, à différents niveaux enterrés dans un substrat semi-conducteur 8. Chaque niveau enterré a une profondeur définie en fonction des longueurs d'ondes correspondantes des différentes couleurs à détecter.

Le photodétecteur chromatique 7 comporte trois couches superposées 9, 10, 11 dans le substrat semi-conducteur 8. La première couche 9 a un premier type de conductivité, par exemple de type n, la deuxième couche 10 a un second type de conductivité, par exemple de type p, et la troisième couche 11 a le même type de conductivité que la première couche 9, à savoir de type n. Le substrat semi-conducteur 8 a le même type de conductivité que la seconde couche 10, à savoir de type p, de sorte qu'il y a une alternance de conductivité entre les différentes couches 9, 10, 11 et le substrat semi-conducteur 8.

La premier jonction J_{R}, de type pn, entre le substrat semi-conducteur 8 et la première couche 9 délimite la profondeur d'absorption approximative de la lumière rouge et forme une première photodiode de détection associée aux longueurs d'ondes de la composante rouge de la lumière.

La deuxième jonction Jᵥ, de type pn, entre la première couche 9 et la deuxième couche 10 délimite la profondeur d'absorption approximative de la lumière verte et forme une deuxième photodiode de détection associée aux longueurs d'ondes de la composante verte de la lumière.

La troisième jonction J_{B}, de type pn, entre la deuxième couche 10 et la troisième couche 11 délimite la profondeur d'absorption approximative de la lumière bleue et forme une troisième photodiode de détection associée aux longueurs d'ondes de la composante bleue de la lumière.

À titre d'exemple, la première jonction J_{R} entre le substrat semi-conducteur 8 et la première couche 9 est formée à une profondeur D1 de l'ordre de 1,5µm à 3µm, de préférence de l'ordre de 2µm. La deuxième jonction Jᵥ entre la première couche 9 et la deuxième couche 10 est formée à une profondeur D2 de l'ordre de 0,5µm à 1,5µm, de préférence de l'ordre de 0,6µm. La troisième jonction J_{B} entre la deuxième couche 10 et la troisième couche 11 est formée à une profondeur D3 de l'ordre de 0,2µm à 0,5µm, de préférence de l'ordre de 0,2µm.

Par ailleurs, les couches 9, 10, 11 et le substrat semi-conducteur 8 sont connectés à un composant de mesure 12, destiné à mesurer les courants photoélectriques passant à travers les trois photodiodes de détection formées par les jonctions J_{R}, Jᵥ, J_{B}, associées aux trois couleurs primaires.

Un tel photodétecteur chromatique, avec empilement des trois couches 9, 10, 11, permet donc de mesurer sur un même emplacement toutes les composantes de la lumière.

Dans le mode particulier de réalisation représenté sur la figure 3, le dispositif 1 d'émission de lumière comporte trois diodes électroluminescentes 3a, 3b, 3c, respectivement associées à trois couleurs primaires, par exemple bleu, vert et rouge. Les diodes électroluminescentes 3a, 3b, 3c émettent une partie de leur signal en direction de la lentille 4, à savoir des faisceaux lumineux Fa, Fb, Fc, et une autre partie de leur signal en direction du substrat de base 2, à savoir des faisceaux lumineux F'a, F'b et F'c. Dans le mode particulier de réalisation représenté sur la figure 3, la lentille 4 est optionnelle.

Le dispositif 1 d'émission de lumière comporte trois photodétecteurs chromatiques 7a, 7b, 7c représentés chacun schématiquement par ses trois couches superposées 9, 10, 11 et fonctionnant chacun comme le photodétecteur chromatique 7 décrit sur la figure 2. Les photodétecteurs chromatiques 7a, 7b, 7c sont formés dans le substrat de base 2, qui constitue alors le substrat semi-conducteur coopérant avec la première couche 9a, 9b, 9c des photodétecteurs 7a, 7b, 7c.

Chaque photodétecteur chromatique 7a, 7b, 7c est disposé sous la diode électroluminescente 3a, 3b, 3c correspondante et comprend trois couches superposées 9a, 10a, 11 a, 9b, 10b, 11 b et 9c, 10c, 11 c formant avec le substrat semi-conducteur les photodiodes de détection pour les trois couleurs primaires correspondantes.

Sur la figure 3, la première jonction J_{R} entre le substrat de base 2 et la première couche 9a du photodétecteur 7a constitue la première photodiode de détection permettant de mesurer l'intensité de la lumière rouge émise par la diode électroluminescente 3a.

La deuxième jonction Jᵥ entre la première couche 9b et la deuxième couche 10b du photodétecteur 7b constitue la deuxième photodiode de détection permettant de mesurer l'intensité de la lumière verte émise par la diode électroluminescente 3b.

La troisième jonction J_{B} entre la deuxième couche 10c et la troisième couche 11 c du photodétecteur 7c constitue la troisième photodiode de détection permettant de mesurer l'intensité de la lumière bleue émise par la diode électroluminescente 3c.

Par ailleurs, les photodétecteurs chromatiques 7a, 7b, 7c, ainsi que les diodes électroluminescentes 3a, 3b, 3c, sont reliés à un même composant de contrôle 6 intégré, formé sur le substrat de base 2, de préférence à l'extérieur de la lentille 4, dans le cas où le dispositif 1 comporte une lentille 4. Le composant de contrôle 6 permet notamment de contrôler les différentes composantes de la lumière, pour contrôler la couleur globale émise par le dispositif 1.

Dans une variante de réalisation non représentée, le dispositif 1 d'émission de lumière peut comporter des groupes de diodes électroluminescentes 3a, 3b, 3c émettant chacun une couleur primaire. Les photodétecteurs chromatiques 7a, 7b, 7c sont alors associés au groupe correspondant de diodes électroluminescentes 3a, 3b, 3c et sont disposés sous les groupes correspondants. Chaque photodétecteur 7a, 7b, 7c présente alors une taille adaptée, afin de pouvoir mesurer une partie suffisante du signal émis par toutes les diodes électroluminescentes 3a, 3b, 3c du groupe correspondant.

À titre d'exemple, un procédé connu d'hybridation par retournement (« flip-chip ») peut être utilisé, pour fabriquer le dispositif 1 d'émission de lumière comme décrit ci-dessus. Comme représenté sur la figure 3, le procédé consiste d'abord à former des billes 14 d'alliage fusible, par exemple en indium ou en alliage d'étain et d'argent, sur le substrat de base 2, de façon précise et contrôlée par rapport à la position des photodétecteurs 7a, 7b, 7c formés dans le substrat 2. Différentes étapes de dépôt, gravure et structuration permettent alors la formation de galettes d'alliage fusible. Puis, la refonte des galettes entraîne la formation des billes 14.

Le procédé consiste ensuite à reporter le composant constituant les diodes électroluminescentes 3a, 3b, 3c sur les billes 14 avec un pré-alignement grossier sur les billes 14. Le composant est doté, de préférence, de surfaces d'accrochage adéquates, afin d'assurer une étape ultérieure de brasage. À titre d'exemple, le composant comporte une tricouche en titane, nickel et or.

Enfin, une étape de brasage est réalisée, afin d'induire un auto-alignement des diodes électroluminescentes 3a, 3b, 3c sur les billes 14. Le positionnement précis des billes 14 par rapport aux photodétecteurs 7a, 7b, 7c assure ainsi un positionnement précis des diodes électroluminescentes 3a, 3b, 3c par rapport aux photodétecteurs chromatiques 7a, 7b, 7c.

Un tel dispositif 1 d'émission de lumière avec un photodétecteur 7a, 7b, 7c, associé à chaque couleur primaire à détecter, permet notamment un contrôle individuel précis de chaque diode électroluminescente 3a, 3b, 3c. Par ailleurs, un tel procédé de fabrication du dispositif 1 d'émission de lumière permet notamment d'optimiser l'alignement des diodes électroluminescentes 3 au-dessus des photodétecteurs 7 et d'améliorer l'efficacité du procédé de fabrication.

Dans une variante de réalisation non représentée, le dispositif 1 d'émission de lumière, comme représenté sur la figure 3, peut notamment comporter uniquement deux diodes électroluminescentes 3, ou deux groupes de diodes électroluminescentes, respectivement associées à deux couleurs distinctes. Le dispositif 1 comporte alors deux photodétecteurs chromatique 7, associés chacun à une diode ou un groupe de diodes et comportant chacun trois couches superposées, comme décrit précédemment, ou uniquement deux couches superposées, ayant des types de conductivités différents. Chaque photodétecteur chromatique 7 à deux couches définit alors uniquement deux jonctions formant des photodiodes de détection associées aux longueurs d'ondes correspondantes des deux couleurs à détecter.

Dans la variante de réalisation représentée sur la figure 4, le dispositif 1 d'émission de lumière se distingue du dispositif 1 décrit précédemment par la lentille 4, qui est, de préférence, partiellement réfléchissante. Les diodes électroluminescentes 3a, 3b, 3c émettent leur signal, notamment des faisceaux Fa, Fb, Fc, uniquement en direction de la lentille 4 et le dispositif 1 d'émission de lumière comporte un unique photodétecteur chromatique 7, disposé latéralement par rapport aux diodes électroluminescentes 3a, 3b, 3c.

Dans le mode particulier de réalisation représenté sur la figure 4, le photodétecteur chromatique 7 est formé sous la lentille 4, dans le substrat de base 2, constituant le substrat semi-conducteur associé aux trois couches 9, 10, 11 du photodétecteur chromatique 7. Le photodétecteur chromatique 7 est destiné à détecter les faisceaux réfléchis F"a, F"b et F"c, associés aux trois couleurs primaires émises par les diodes électroluminescentes 3a, 3b, 3c.

Le fonctionnement du photodétecteur chromatique 7 est identique au fonctionnement décrit à la figure 2. La première jonction J_{R} entre le substrat de base 2 et la première couche 9 est associée à la détection des faisceaux lumineux réfléchis F"a, correspondant à la composante rouge de la lumière. La deuxième jonction Jᵥ entre la première couche 9 et la deuxième couche 10 est associée à la détection des faisceaux lumineux réfléchis F"b, correspondant à la composante verte de la lumière. La troisième jonction J_{B} entre la deuxième couche 10 et la troisième couche 11 est associée à la détection des faisceaux lumineux réfléchis F"c, correspondant à la composante bleue de la lumière.

Comme précédemment, un composant de contrôle 6 est connecté à la fois aux diodes électroluminescentes 3a, 3b, 3c et au photodétecteur chromatique 7, pour contrôler la couleur globale émise par le dispositif 1 d'émission de lumière.

Un tel dispositif 1 d'émission de lumière, avec un seul photodétecteur chromatique 7, permet notamment un contrôle global de la couleur émise par le dispositif. Il offre également une possibilité de détection de la lumière ambiante. Par ailleurs, les diodes électroluminescentes utilisées dans le dispositif 1 sont de fabrication et de conception classiques. Il en résulte une simplicité de fabrication d'un tel dispositif 1 d'émission de lumière.

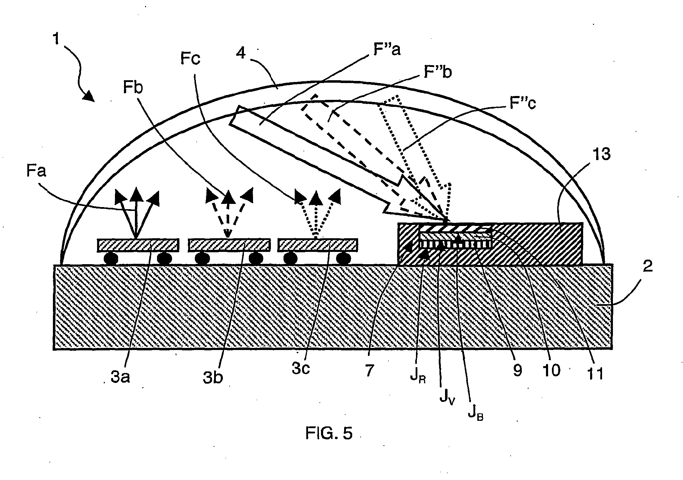

Dans la variante de réalisation représentée sur la figure 5 qui ne fait pas partie de l'invention revendiquée, le dispositif 1 d'émission de lumière se distingue du dispositif 1 décrit précédemment par un composant de contrôle 13 intégré sur le substrat de base 2 et sous la lentille 4 partiellement réfléchissante.

Le photodétecteur chromatique 7 est formé sur le substrat de base 2 et, de préférence, dans le composant de contrôle 13 intégré, placé sous la lentille 4 latéralement par rapport aux diodes électroluminescentes 3a, 3b, 3c. Le composant de contrôle 13 constitue alors le substrat semi-conducteur coopérant avec les trois couches 9, 10, 11 du photodétecteur chromatique 7, pour la détection des différentes composantes de la lumière.

Comme précédemment, les diodes électroluminescentes 3a, 3b, 3c émettent des faisceaux Fa, Fb, Fc en direction de la lentille 4 partiellement réfléchissante et le photodétecteur chromatique 7 détecte les faisceaux F"a, F"b, F"c réfléchis par la lentille 4.

La première jonction J_{A} entre le composant de contrôle 13 et la première couche 9 est associée à la détection des faisceaux lumineux réfléchis F"a, correspondant à la composante rouge de la lumière. La deuxième jonction Jᵥ entre la première couche 9 et la deuxième couche 10 est associée à la détection des faisceaux lumineux réfléchis F"b, correspondant à la composante verte de la lumière. La troisième jonction J_{B} entre la deuxième couche 10 et la troisième couche 11 est associée à la détection des faisceaux lumineux réfléchis F"c, correspondant à la composante bleue de la lumière.

Par ailleurs, le composant de contrôle 13 intégré est connecté aux diodes électroluminescentes 3a, 3b, 3c, afin de mesurer et contrôler la couleur globale émise par le dispositif 1.

Un tel dispositif 1 d'émission de lumière, avec le photodétecteur chromatique 7 intégré dans le composant de contrôle 13, permet notamment d'intégrer complètement les fonctions de contrôle et de détection chromatique du dispositif 1. Par ailleurs, le substrat de base 2 peut servir uniquement pour la connexion électrique et le contrôle thermique du dispositif 1 d'émission de lumière.

Dans d'autres variantes de réalisation non représentées, le dispositif 1 d'émission de lumière, comme représenté sur les figures 4 et 5, peut comporter un groupe de diodes électroluminescentes 3a, 3b, 3c pour chaque couleur émise. Le fonctionnement du dispositif 1 d'émission de lumière reste le même, les dimensions du photodétecteur chromatique 7 étant adaptées, pour détecter au moins une partie suffisante de la lumière réfléchie par la lentille 4.

Par ailleurs, le dispositif 1 d'émission de lumière, comme représenté sur les figures 4 et 5, peut être fabriqué selon le même procédé d'hybridation par retournement décrit ci-dessus, avec auto-alignement induit par brasage et formation de billes 14 par refonte de galettes d'alliage fusible.

Dans d'autres variantes de réalisation non représentées, le dispositif 1 d'émission de lumière, comme représenté sur les figures 4 et 5, peut comporter uniquement deux diodes électroluminescentes 3, ou deux groupes de diodes électroluminescentes, respectivement associées à deux couleurs distinctes. Le photodétecteur chromatique 7 associé, disposé latéralement par rapport aux diodes, dans le substrat 2 (figure 4) ou sur le substrat 2, intégré dans le composant de contrôle 13 (figure 5), peut alors comporter trois couches superposées, comme décrit précédemment sur la figure 2, ou uniquement deux couches superposées formant deux jonctions servant de photodiodes de détection associées aux longueurs d'ondes correspondantes des deux couleurs à détecter.

Quel que soit le mode de réalisation du dispositif 1 d'émission de lumière décrit ci-dessus, celui-ci permet un contrôle chromatique optimal de la couleur globale de la lumière émise. Le dispositif 1 permet également de compenser les disparités entre les divers groupes de diodes électroluminescentes 3 et de contrôler les dérives chromatiques des diodes électroluminescentes 3. Il en résulte l'amélioration de la fiabilité à long terme du système de régulation chromatique.

Par tailleurs, un tel dispositif 1 d'émission de lumière est très compact et très simple à fabriquer, notamment selon des procédés classiques d'hybridation par retournement.

L'invention n'est pas limitée aux différents modes particuliers de réalisation décrits ci-dessus. Dans le cas de l'utilisation de groupes de diodes électroluminescentes pour émettre les couleurs, celles-ci peuvent être disposées de façon régulière sur le substrat de base 2, par exemple sous forme de matrice bidimensionnelle, ou de façon aléatoire, tant que le photodétecteur chromatique associé à cette couleur peut détecter l'ensemble des faisceaux émis par les diodes électroluminescentes 3 (figure 3) ou réfléchis par la lentille 4 (figures 4 et 5).

Sur la figure 2, le substrat semi-conducteur 8 du photodétecteur chromatique 7 peut avoir le second type de conductivité, à savoir de type n, et les couches superposées 9, 10, 11 peuvent également avoir l'autre type de conductivité, à savoir respectivement de type p, de type n, et de type p.

Les dimensions D1, D2 et D3 des profondeurs de jonction J_{R}, Jᵥ, J_{B} sont non limitatives et dépendent essentiellement de la taille générale du photodétecteur chromatique 7.

Un tel dispositif 1 d'émission de lumière, selon les différents modes de réalisation décrits ci-dessus, peut notamment s'appliquer au domaine de l'éclairage grand public, à l'art, etc.

## Revendications

1. Dispositif d'émission de lumière comportant :
- un substrat de base (2),
- au moins deux diodes électroluminescentes (3a, 3b, 3c), respectivement associées à deux couleurs distinctes et disposées côte à côte sur ledit substrat de base (2),
- des moyens de détection chromatique,
- des moyens de contrôle, connectés auxdits moyens de détection chromatique et aux diodes électroluminescentes (3a, 3b, 3c), pour contrôler la couleur globale de la lumière émise par le dispositif (1),
dispositif **caractérisé en ce que** :
- les moyens de détection chromatique comportent au moins un photodétecteur chromatique (7) mesurant les composantes chromatiques du signal émis par les diodes électroluminescentes (3a, 3b, 3c) à différents niveaux enterrés dans le substrat de base (2) et respectivement associés à des longueurs d'ondes correspondant aux composantes chromatiques,
- ledit photodétecteur chromatique (7) comporte au moins des première (9) et deuxième (10) couches superposées dans ledit substrat de base (2), la première (9) couche ayant un premier type de conductivité et la seconde couche (10) ayant un second type de conductivité.

2. Dispositif selon la revendication 1, **caractérisé en ce que** le dispositif comporte trois diodes électroluminescentes (3a, 3b, 3c), respectivement associées à trois couleurs primaires.

3. Dispositif selon l'une des revendications 1 et 2, **caractérisé en ce que** le photodétecteur chromatique (7) comporte des première (9), deuxième (10) et troisième (11) couches superposées dans ledit substrat de base (2), les première (9) et troisième (11) couches ayant un premier type de conductivité et la seconde couche (10) ayant un second type de conductivité.

4. Dispositif selon l'une quelconque des revendications 1 à 3, **caractérisé en ce que**, les diodes électroluminescentes (3a, 3b, 3c) émettant au moins une partie de leur signal en direction du substrat de base (2), les moyens de détection chromatique comportent au moins deux photodétecteurs chromatiques (7a, 7b, 7c) formés dans le substrat de base (2), et disposés chacun sous une diode électroluminescente (3a, 3b, 3c) associée.

5. Dispositif selon la revendication 4, **caractérisé en ce que**, chaque couleur étant émise par un groupe de diodes électroluminescentes (3a, 3b, 3c), chaque photodétecteur chromatique (7a, 7b, 7c) est disposé sous un groupe associé.

6. Dispositif selon l'une quelconque des revendications 1 à 3, **caractérisé en ce qu'**il comporte une lentille (4) partiellement réfléchissante, disposée au-dessus des diodes électroluminescentes (3a, 3b, 3c).

7. Dispositif selon la revendication 6, **caractérisé en ce que**, le photodétecteur chromatique (7) détectant au moins une partie de la lumière réfléchie par la lentille (4), le photodétecteur chromatique (7) est disposé latéralement par rapport aux diodes électroluminescentes (3a, 3b, 3c) sous la lentille (4).

8. Dispositif selon la revendication 7, **caractérisé en ce que** chaque couleur est émise par un groupe de diodes électroluminescentes (3a, 3b, 3c).

## Claims

1. Light-emitting device comprising:
- a base substrate (2),
- at least two light-emitting diodes (3a, 3b, 3c) respectively associated with two different colors and arranged side by side on said base substrate (2),
- chromatic detection means,
- control means, connected to said chromatic detection means and to the light-emitting diodes (3a, 3b, 3c), to control the global color of the light emitted by the device (1),
a device **characterized in that**:
- the chromatic detection means comprise at least one chromatic photodetector (7) measuring the chromatic components of the signal emitted by the light-emitting diodes (3a, 3b, 3c) at different buried levels in the base substrate (2) and respectively associated with wavelengths corresponding to the chromatic components,
- said chromatic photodetector (7) comprises at least first (9) and second (10) superposed layers in said base substrate (2), the first (9) layer having a first type of conductivity and the second layer (10) having a second type of conductivity.

2. Device according to claim 1, **characterized in that** the device comprises three light-emitting diodes (3a, 3b, 3c) respectively associated with three primary colors.

3. Device according to one of claims 1 and 2, **characterized in that** the chromatic photodetector (7) comprises first (9), second (10) and third (11) superposed layers in said base substrate (2), the first (9) and third (11) layers having a first type of conductivity and the second layer (10) having a second type of conductivity.

4. The device according to any one of claims 1 to 3, **characterized in that**, the light-emitting diodes (3a, 3b, 3c) emitting at least a part of their signal in the direction of the base substrate (2), the chromatic detection means comprise at least two chromatic photodetectors (7a, 7b, 7c) formed in the base substrate (2) and each arranged under an associated light-emitting diode (3a, 3b, 3c).

5. The device according to claim 4, **characterized in that**, each color being emitted by a group of light-emitting diodes (3a, 3b, 3c), each chromatic photodetector (7a, 7b, 7c) is arranged under an associated group.

6. The device according to any one of claims 1 to 3, **characterized in that** it comprises a partially reflecting lens (4) arranged above the light-emitting diodes (3a, 3b, 3c).

7. The device according to claim 6, **characterized in that**, the chromatic photodetector (7) detecting at least a part of the light reflected by the lens (4), the chromatic photodetector (7) is arranged laterally with respect to the light-emitting diodes (3a, 3b, 3c) under the lens (4).

8. The device according to claim 7, **characterized in that** each color is emitted by a group of light-emitting diodes (3a, 3b, 3c).

## Patentansprüche

1. Lichtemissionsvorrichtung umfassend:
- ein Grundsubstrat (2),
- wenigstens zwei Leuchtdioden (3a, 3b, 3c), die jeweils zwei unterschiedlichen Farben zugeordnet und auf dem Grundsubstrat (2) nebeneinander angeordnet sind,
- Farberfassungsmittel,
- Kontrollmittel, die mit den Farberfassungsmitteln und mit den Leuchtdioden (3a, 3b, 3c) verbunden sind, um die Gesamtfarbe des durch die Vorrichtung (1) ausgesandten Lichts zu kontrollieren,
Vorrichtung, **dadurch gekennzeichnet, dass**:
- die Farberfassungsmittel wenigstens einen Farbphotodetektor (7) umfassen, der die chromatischen Komponenten des durch die Leuchtdioden (3a, 3b, 3c) ausgesandten Signals in unterschiedlichen Ebenen, die in dem Grundsubstrat (2) verdeckt liegen und jeweils den chromatischen Komponenten entsprechenden Wellenlängen zugeordnet sind, misst,
- der Farbphotodetektor (7) wenigstens eine erste Schicht (9) und eine zweite Schicht (10) umfasst, die in dem Grundsubstrat (2) übereinander angeordnet sind, wobei die erste Schicht (9) einen ersten Leitfähigkeitstyp und die zweite Schicht (10) einen zweiten Leitfähigkeitstyp aufweist.

2. Vorrichtung nach Anspruch 1, **dadurch gekennzeichnet, dass** die Vorrichtung drei Leuchtdioden (3a, 3b, 3c) aufweist, die jeweils drei Grundfarben zugeordnet sind.

3. Vorrichtung nach einem der Ansprüche 1 und 2, **dadurch gekennzeichnet, dass** der Farbphotodetektor (7) eine erste Schicht (9), eine zweite Schicht (10) und eine dritte Schicht (11) umfasst, die in dem Grundsubstrat (2) übereinander angeordnet sind, wobei die erste Schicht (9) und die dritte Schicht (11) einen ersten Leitfähigkeitstyp aufweisen und die zweite Schicht (10) einen zweiten Leitfähigkeitstyp aufweist.

4. Vorrichtung nach einem der Ansprüche 1 bis 3, **dadurch gekennzeichnet, dass** - da die Leuchtdioden (3a, 3b, 3c) wenigstens einen Teil ihres Signals in Richtung des Grundsubstrats (2) aussenden - die Farberfassungsmittel wenigstens zwei Farbphotodetektoren (7a, 7b, 7c) umfassen, die in dem Grundsubstrat (2) ausgebildet und jeweils unter einer zugeordneten Leuchtdiode (3a, 3b, 3c) angeordnet sind.

5. Vorrichtung nach Anspruch 4, **dadurch gekennzeichnet, dass** - da jede Farbe von einer Gruppe von Leuchtdioden (3a, 3b, 3c) ausgesandt wird - jeder Farbphotodetektor (7a, 7b, 7c) unter einer zugeordneten Gruppe angeordnet ist.

6. Vorrichtung nach einem der Ansprüche 1 bis 3, **dadurch gekennzeichnet, dass** sie eine teilweise reflektierende Linse (4) umfasst, die oberhalb der Leuchtdioden (3a, 3b, 3c) angeordnet ist.

7. Vorrichtung nach Anspruch 6, **dadurch gekennzeichnet, dass** - da der Farbphotodetektor (7) wenigstens einen Teil des durch die Linse (4) reflektierten Lichts erfasst - der Farbphotodetektor (7) in Bezug auf die Leuchtdioden seitlich unter der Linse (4) angeordnet ist.

8. Vorrichtung nach Anspruch 7, **dadurch gekennzeichnet, dass** jede Farbe von einer Gruppe von Leuchtdioden (3a, 3b, 3c) ausgesandt wird.
